# EUROPEAN PATENT APPLICATION

(11) **EP 4 016 649 A1**
(43) Date of publication of application: **22.06.2022**
(21) Application number: 20852446.2
(22) Date of filing: 28.06.2020
(51) Int. Cl.: H01L 33/48, H01L 33/56, H01L 33/58

(54) **LIGHT-EMITTING DEVICE AND MANUFACTURING METHOD, AND DISPLAY SCREEN AND LIGHTING EQUIPMENT COMPRISING SAID LIGHT-EMITTING DEVICE**

(30) Priority: 12.08.2019 CN 201910738265
(71) Applicant: Quanzhou Sanan Semiconductor Technology Co., Ltd., Quanzhou, Fujian 362343 (CN)
(72) Inventor: LI, Xinglong, Xiamen, Fujian 361009 (CN); HSU, Chen-Ke, Xiamen, Fujian 361009 (CN); SHI, Junpeng, Xiamen, Fujian 361009 (CN); WONG, Weng-Tack, Xiamen, Fujian 361009 (CN)
(74) Representative: Petraz, Gilberto Luigi
(86) International application number: PCT/CN2020/098498
(87) International publication number: WO 2021/027405

(57) **Abstract**

A light-emitting device and a manufacturing method, and a display screen and lighting equipment comprising said light-emitting device, the light-emitting device comprising: at least three LED chips (20) that are spaced apart from one another, the at least three LED chips (20) being configured to emit light of respective wavelengths, and the maximum diameter D of the light-emitting region thereof being less than 1 mm; an encapsulation layer (30) covering the side surface of the at least three LED chips (20) and filling the gaps between the at least three LED chips (20); and a lens (10) arranged above a first surface of the at least three LED chips (20) and covering the light-emitting region of the at least three LED chips (20). The present light-emitting device does not have a traditional carrier substrate or bracket and is secured by means of the encapsulation layer (30), and therefore does not need to undergo die bonding by means of die bonding glue, such that the distance between the chips (20) can be reduced to less than 30 µm, better controlling the uniformity of the light emission angle of the light-emitting device. The lens (10) being arranged above the light-emitting region of the light-emitting device enables the light to be irradiated in a more concentrated manner onto the desired area of application.

## Description

### RELATED APPLICATIONS

This application claims priority to Chinese Patent Application No. 201910738265.4, entitled " LIGHT-EMITTING DEVICE, MANUFACTURING METHOD THEREOF, AND DISPLAY AND LIGHTING APPARATUS COMPRISING THE LIGHT-EMITTING DEVICE ", filed August 12, 2019, the entire contents of which are incorporated by reference in this application.

### TECHNICAL FIELD

The present invention relates to the field of semiconductor components, in particular to a light-emitting device, a method of manufacturing the light-emitting device, and a display and lighting apparatus including the light-emitting device.

### BACKGROUND

LED package provides effective mechanical protection to the chip, enhances heat dissipation, improves the light efficiency, and optimizes the beam distribution, so the LED package structure is an important factor affecting the performance of display devices or lighting apparatuses.

The traditional display mostly uses the pin-type packaging (Lamp LED), which is suitable for small current(20-30mA), low power (less than 0.1W) LED packages, for example, used in instrument display or indication. Although they may also be used in a display screen by large-scale integration, there are disadvantage including higher package thermal resistance (generally higher than 100K / W), poor heat dissipation, low lifespan. Especially for outdoor display for traffic, they don't only have the disadvantages including poor reliability performance, low lifespan, low integration, but also cannot achieve color display, resulting in a reduced display effect.

In addition, in the traffic display, advertising display and other applications, in order to improve the utilization of light energy, and to prevent non-illuminated areas such as roads, from LED light pollution, LED needs to narrow the emitting angle, and it requires that a horizontal illumination area of LED is larger than a vertical illumination area. However, in existing technology, conventional LED chips are placed on the carrier substrate by die bonding. Due to the error of the die bonding machine itself (an error is generally in ± 15µm for a good die bonding machine, and ± 5µm for those with the highest precision in the industry) and the fact that the adhesive for die bonding in the baking (for front mount chip) or back to the process (for flip chip) will be displaced, the distance between the existing die boding chip is usually 50 µm or more, and the minimum is at least more than 30 µm. In the use of the lens to narrow the emitting angle, then the lighting center of R\G\B chips is difficult to be located in the center of the lens, leading to a large difference in the emitting angle of the chip.

Therefore, under the premise of improving the reliability performance, the structure of the special light distribution and RGB color display package is realized, which puts forward new and higher requirements for the LED package, and a new technical idea must be adopted for package design.

### SUMMARY

### TECHNICAL SOLUTIONS

In view of the above-described shortcomings of the prior art, it is an object of the present invention to provide a light-emitting device, a method of manufacturing the light-emitting device, a display and a lighting apparatus including the light-emitting device for solving the problem that the existing light-emitting device cannot be integrated with a small size and the problem that there is a wider lighting-emitting angle.

In order to achieve the above and other related purposes, one aspect of the present invention provides a light-emitting device, comprising:
at least three LED chips that are spaced apart from each other, each of the LED chips being configured to emit light of a respective wavelength, a maximum diameter D of a light-emitting region of the at least three LED chips being 1 mm or less, each of the LED chips comprising a first surface and a second surface opposite to the first surface, and a side surface interconnecting the first surface and the second surface;
an encapsulation layer that covers the side surfaces of the at least three LED chips and fills the gaps between the at least three LED chips; and
a lens provided above the first surfaces of the at least three LED chips and covering the light-emitting region of the at least three LED chips.

Preferably, more than 70% of light emitted by the at least three LED chips is emitted from the first surface.

Preferably, a luminous power emitted from the encapsulation layer is less than 30% of a total luminous power.

Further, the encapsulation layer is filled with colored silicone or silicone resin with a transmittance less than or equal to 20%.

Preferably, a contact surface between the lens and the encapsulation layer is approximately an ellipse with a ratio a/b of a minor axis length a to a major axis length b greater than or equal to 0.4, and less than or equal to 0.9, the minor axis length a is greater than or equal to 1.5 times the maximum diameter D of the light-emitting region, and a height h of the semi-ellipsoid is greater than 0.5a.

Further, the lens is a semi-flat ellipsoid, and an approximately elliptical surface is formed at the connection between the lens and encapsulation layer. A half-value angle corresponding to the minor axis is α, and a half-value angle corresponding to the major axis is β, where α<β, 20°<α<70°.

Preferably, the half-value angle α corresponding to the minor axis of the lens is greater than 30° and less than 50°.

Further, when looking down from the lens side towards the LED chip side, the geometric center of the light-emitting region of the at least three LED chips coincide with an optical axis of the lens.

Preferably, the lens is made of silicone or resin by an injection molding process.

Preferably, the at least three LED chips each have a size of 380 µm x 380 µm or less.

Preferably, a spacing between the at least three LED chips is 50µm or less.

Preferably, the light-emitting assembly does not have a packaging substrate for carrying the LED chips, and the LED chips are held in position by the encapsulation layer.

Preferably, a carrier substrate is provided under the encapsulation layer, a lower surface of the carrier substrate is provided with exposed electrodes, a circuit layer of the light-emitting device is provided in the encapsulation layer on the carrier substrate, and connection wires between the electrodes and the circuit layer extend through vias within the carrier substrate.

Preferably, a light scattering and mixing layer is further provided above the at least three LED chips.

Further, the light scattering and mixing layer is formed by curing and molding light-transmitting silicone or resin with scattering particles uniformly distributed therein.

Preferably, the light-emitting device comprises only three LED chips, which are respectively a R-light chip, a G-light chip and a B-light chip.

Further, the three LED chips are triangularly arranged or linearly arranged.

Preferably, cathodes or anodes of at least three LED chips are led out through a common-cathode electrical connection structure or a common-anode electrical connection structure.

Preferably, exposed electrodes are provided on a side of the light-emitting device opposite to the first surface.

Further, the electrodes are SMT electrodes capable of being soldered.

Further, a circuit layer of the light-emitting assembly is provided within the encapsulation layer on the second surface side of the at least three LED chips.

Another aspect of the present invention provides a display, comprising an electrical connection unit, a case, a screen and any one of the light-emitting devices mounted thereon as described above, the light-emitting device being mounted on the screen as a pixel point.

The present invention also provides a lighting apparatus, comprising a bracket and a light-emitting assembly, the light-emitting assembly comprising any one of the light-emitting devices as described above.

The present invention also provides a manufacturing method for a light-emitting device, comprising the steps of:
(1) providing at least three LED chips, the LED chip comprising a first surface and a second surface opposite to the first surface, and a side surface interconnecting the first surface and the second surface, the second surface having a pair of electrodes provided thereon; and adhering the at least three LED chips to a tape spaced apart from each other, while making the second surfaces of the at least three LED chips face upward in the same plane;
(2) forming an encapsulation layer that fills the gaps between the at least three LED chips and covers the side surface of each LED chip, exposing an electrode surface of each LED chip;
(3) forming a circuit layer on the electrode surfaces of the at least three LED chips, and connecting the circuit layer to the electrodes of the at least three LED chips;
(4) making an insulating layer on the circuit layer, exposing electrode leads of the circuit layer;
(5) removing the tape; and
(6) forming a lens on light exiting surfaces of the LED chips.

Preferably, between steps (5) and (6), the method further comprises a process of making a light scattering and mixing layer above the plurality of chips.

Preferably, the encapsulation layer is formed by curing and molding colored silicone or silicone resin with a transmittance less than or equal to 20%.

Preferably, the lens is made of silicone or resin by an injection molding process.

### BENEFICIAL EFFECTS OF THE INVENTION

### BENEFICIAL EFFECTS

The light-emitting device of the present invention does not have a conventional carrier substrate or support, and instead employs an encapsulation layer covering the side surfaces of at least three LED chips and filling the gaps between at least three LED chips so as to fix the at least three LED chips. This structure not only improves the production efficiency, reduces the production cost of LED, and no adhesive for die bonding is needed, reducing the spacing between the chips to be less than 30µm, and better controlling the consistency of the light-emitting angles of the light-emitting device. The light-emitting device of the present invention has a lens provided above the light-emitting region of at least three LED chips, which changes the approximately Lambertian light distribution of the LED chips, and provides a special light distribution. The special light field distribution allows the light to be more concentrated on desired areas, which effectively improve the utilization of light energy, reduces the energy consumption and cost of the light source, while avoiding light pollution from the light source to the non-illuminated areas and other issues. In addition, the maximum diameter D of the light-emitting region of the light-emitting device in the present invention is less than 1 mm, which effectively reduces the error of the overlap of the center of the light-emitting region and the center of the lens, and which effectively reduces the difference in the light-emitting angles of the light-emitting device.

The light mixing structure layer on the light-emitting device of the present invention effectively improves the light uniformity of the LED chips, and in addition the gaps between at least three LED chips in the present invention are filled by colored silicone or silicone resin with a transmittance of less than or equal to 20%, which makes the light interference between neighboring display units greatly reduced after formation of the LED display by splicing.

When the display of the present invention uses the light-emitting device of the present invention as a pixel unit mounted on the display, the encapsulation layer makes the light interference between neighboring display units greatly reduced after formation of the LED display by splicing.

### DESCRIPTION OF THE DRAWINGS

FIG. 1 is a three-dimensional view of a light-emitting device according to a first embodiment of the present invention.
FIG. 2 is a top view of a structure of the light-emitting device from the lens side toward the LED chip side according to the first embodiment of the present invention.
FIG. 3 is a cross-sectional view taken along A-A in FIG. 2.
FIG. 4 is an inverted three-dimensional view of the light-emitting device according to the first embodiment of the present invention.
FIG. 5 is a diagram showing locations of the semi-flat ellipsoid and the center of the light-emitting region of three LED chips in the light-emitting device according to the first embodiment of the present invention.
FIG. 6 is a schematic diagram showing a height of the semi-flat ellipsoid of the light-emitting device according to the first embodiment of the present invention.
FIG. 7 is a top view of a structure of a light-emitting device from the lens side toward the LED chip side according to a second embodiment of the present invention.
FIG. 8 is a cross-sectional view taken along B-B in FIG. 7.
FIG. 9 is an inverted three-dimensional view of the light-emitting device according to the second embodiment of the present invention.
FIG. 10 is a three-dimensional view of a light-emitting device according to a third embodiment of the present invention.
FIG. 11 is a top view of a structure of the light-emitting device from the lens side toward the LED chip side according to the third embodiment of the present invention.
FIG. 12 is a cross-sectional view taken along C-C in FIG. 11.
FIG. 13 is a diagram showing locations of a semi-flat ellipsoid and centers of the light-emitting region of three LED chips in the light-emitting device according to the third embodiment of the present invention.
FIG. 14 is schematic diagram showing a height of the semi-flat ellipsoid of the light-emitting device according to the third embodiment of the present invention.
FIG. 15 is a structural diagram of a light-emitting device according to a fourth embodiment of the present invention;
FIG. 16 is a light intensity distribution diagram of an existing light-emitting device;
FIG. 17 is a light intensity distribution diagram of the light-emitting device according to the present invention.

### Description of component reference

10: lens; 20: LED chip; 30: encapsulation layer; 40: circuit layer; 50: electrode; 60: carrier substrate; 61: via; 70: light scattering and mixing layer

### EMBODIMENTS OF THE INVENTION

Embodiments of the present invention are described below through specific examples. Those skilled in the art may easily learn other advantages and functions of the present invention from the content disclosed in the specification. The present invention also may be implemented or applied through other different embodiments, and what details described in the present invention may be modified or changed based on different views and applications without departing from the spirit of the present invention.

It should be noted that the parts that are not specifically described in the following embodiments are all existing structures or conventional manufacturing processes, and the figures provided in the following embodiments are only illustrative to illustrate the basic concept of the present invention. Although only the components related to the present invention are shown in the figures which is not drawn according to the number, shape and size of the components in actual implementations, the form, number and proportion of each component in actual implementation can be changed, and its layout may also be more complex.

### Embodiment I

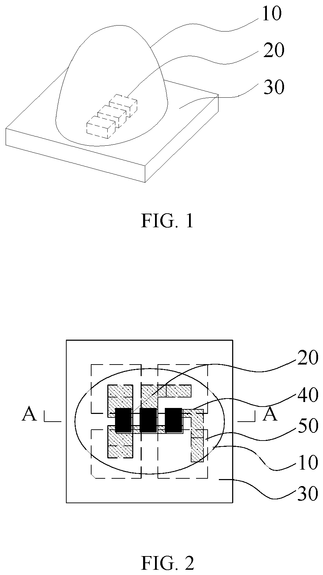

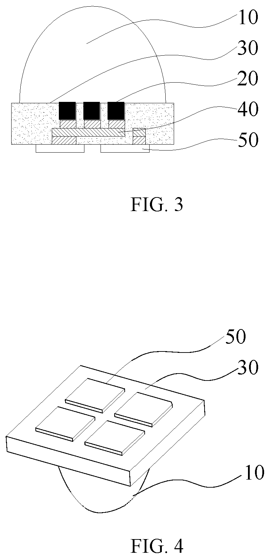

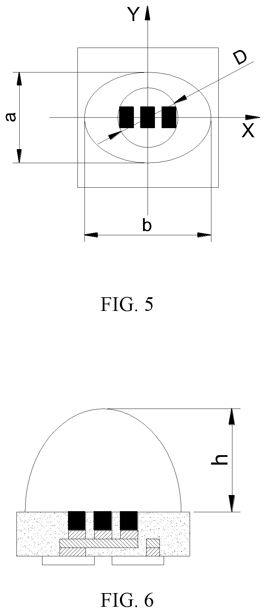

As shown in FIGS. 1-6, the present invention provides a light-emitting device comprising:
at least three LED chips 20 that are spaced apart from each other, the at least three LED chips 20 being configured to emit light of respective wavelengths, the at least three LED chips 20 having a light-emitting region with a maximum diameter D of 1 mm or less, each of the LED chips 20 comprising a first surface and a second surface opposite to the first surface, and a side surface interconnecting the first surface and the second surface;
an encapsulation layer 30 covering the side surfaces of the at least three LED chips 20 and filling the gaps between the at least three LED chips 20;
a lens 10 provided above the first surface of the at least three LED chips 20 and covering the light-emitting region of the at least three LED chips 20.

The light-emitting device of the present invention does not use a conventional substrate or support but uses the encapsulation layer 30 to cover the side surfaces of at least three LED chips 20 and fills the gaps between at least three LED chips 20 to fix the at least three LED chips 20. This structure not only improves the production efficiency and reduces the production cost of LED, but also has no need to bond dies through die bond adhesive, such that the spacing between the chips may be smaller to less than 30µm, which can better control the consistency of the light-emitting angles of the light-emitting device. The light-emitting device of the present invention has a lens 10 provided above the light-emitting region of at least three LED chips 20, which changes the approximately Lambertian light distribution of the LED chips 20, and provides a special light distribution. The special light distribution allows the light to be more concentrated on desired areas, which effectively improve the utilization of light energy, reduces the energy consumption and cost of the light source, while avoiding light pollution from the light source to the non-illuminated areas and other issues. In addition, the maximum diameter D of the light-emitting region of the light-emitting device in the present invention is less than 1 mm, which effectively reduces the error of the overlap of the center of the light-emitting region and the center of the lens, and which effectively reduces the difference in the light-emitting angles of the light-emitting device.

For ease of explanation, the light-emitting device in this embodiment includes three LED chips 20, however, it should be noted that the light-emitting device in the present invention may also include only three LED chips or more than three LED chips, such as four, or five micro-LEDs (100µm × 100µm or less), as long as it meets that the maximum diameter of the light-emitting region D is less than 1mm. The three LED chips 20 can emit different light. Considering a wide range of applications, the three LED chips 20 in this embodiment are R-light chip, G-light chip and B-light chip, which can emit red light, green light and blue light correspondingly.

In principle, it is unnecessary to limit the emitting rate of the first surface of the LED chip 20 in the present invention, however, in order to improve energy efficiency, preferably, the luminous power emitted from the encapsulation layer in this embodiment is less than 30% of the total luminous power, i.e., more than 70% of the light emitted by at least three LED chips 20 is emitted from the first surface.

Considering that the light from the LED chips 20 is mostly emitted from the first surface, and the encapsulation layer 30 covers the side surfaces of at least three LED chips 20 and fills the gaps between the at least three LED chips 20, the color of the encapsulation layer 30 in the present invention can be unlimited. However, in order to reduce the light pollution to the non-illuminated area due to the light from the encapsulation layer 30, preferably, the encapsulation layer 30 in this embodiment uses silicone or resin with a transmittance of 30% or less, for example, 20%, 10%, or 0%, etc., which is less than 30%. The smaller the transmittance is, the better the light-shielding effect will be. In this embodiment, the transmittance of the encapsulation layer 30 is 20%, and may be black or other dark colors. The black or dark color encapsulation layer 30 improves contrast of the display device. More preferably, the encapsulation layer 30 preferably adopts colored silicone or colored silicone resin with a transmittance less than or equal to 20%.

The lens 10 in the present invention is a primary packaged lens of a raised shape with only one light exiting surface. The light exiting surface is raised away from the LED chip 20, and its raised shape may be adjusted depending on the light distribution to be achieved. However, in order to achieve different half-value angles in the X and Y directions to make sure that a lateral illumination area of the LED is larger than a longitudinal illumination area, the lens 10 in this embodiment is preferably a semi-flat ellipsoid. An approximately elliptical surface is formed at the connection between the lens and the encapsulation layer (the approximately elliptical surface refers to a shape that the profile of the surface is approximately or close to an ellipse). A half-value angle corresponding to the minor axis is α, and a half-value angle corresponding to the major axis is β, where α<β, 20°<α<70°.α may be any angle from 20° to 70°, such as 25°, 30°, 50°, 60°, or 65°, etc. Preferably, the half-value angle α corresponding to the minor axis of the lens 10 in this embodiment is preferably any angle from 30° to 50°, such as 35°, 40°, or 45°, etc.

In order to further narrow the light-emitting angles, the ratio a/b of the minor axis length a to the major axis length b of the semi-ellipsoid in this embodiment satisfies the following condition: 0.4 ≤ a/b ≤ 0.9, and the minor axis length a is greater than or equal to 1.5 times the maximum diameter D of the light-emitting region, where a/b may be any value from 0.4 to 0.9 (including 0.4 and 0.9), such as 0.4, 0.65, 0.7, 0.75, 0.8, 0.85, or 0.9, etc. The height h of the semi-ellipsoid is greater than 0.5a.

In order to achieve better light distribution and reduce the difference in the light-emitting angles of the chips, the geometric center of the light-emitting region of at least three LED chips 20 is coincident with the optical axis of the lens 10 when viewed from the lens 10 side down toward the LED chip 20 side in this embodiment.

The lens 10 in this embodiment is made of silicone or resin by an injection molding process. During the process, a mold for the lens 10 is connected to the LEDs connected together, and the cavity formed between the LEDs and the lens 10 mold is filled with thermosetting silicone or epoxy resin, which is heated and molded to form the lens 10 in the shape of the mold for the lens 10.

Considering that the maximum diameter D of the light-emitting region required in the present invention is not greater than 1 mm, preferably, the LED chip 20 in this embodiment preferably uses a mini-LED with a size of 380 µm × 380 µm or less or a micro-LED with a size of 100 µm × 100 µm or less. In this embodiment a mini-LED with a size of 380 µm × 380 µm or less is used.

The spacing between the three LED chips 20 in this embodiment is 50 µm or less, which may be 40 µm, 30 µm, 20 µm, 10 µm, or 5 µm, etc.

Considering that in the light-emitting device of the present invention, the LED chip 20 can be just held through the encapsulation layer 30, preferably, the light-emitting assembly in this embodiment does not employ a packaging substrate for carrying the LED chips 20, and LED chips 20 are positioned by the encapsulation layer 30 instead. This structure without packaging substrate not only improves the production efficiency and reduces the production cost of LED, but also has no need to bond dies through die bond adhesive, such that the spacing between the chips may be as small as less than 30µm, which can better control the consistency of the light-emitting angles of the light-emitting device.

The three LED chips 20 in this embodiment can be arranged in a variety of ways, preferably, in order to facilitate production, the three LED chips 20 in this embodiment are linearly arranged. In addition, the cathodes or anodes of the LED chips are led out through a common-cathode electrical connection structure or a common-anode electrical connection structure, and a side of the light-emitting device away from the first surface is provided with bare electrodes 50. In order to facilitate the mounting of the device, the electrodes 50 are SMT electrodes which can be soldered.

The circuit layer 40 of the light-emitting assembly in this embodiment may be additionally provided with an insulating layer, or insulated through the encapsulation layer. The circuit layer 40 in this embodiment is provided within the encapsulation layer 30 on the second surface side of the three LED chips 20, and insulated through the encapsulation layer 30.

### Embodiment II

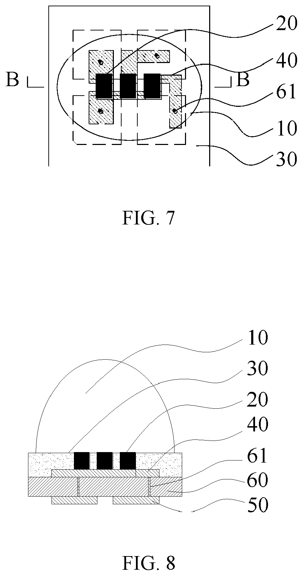

As shown in FIGS. 7-9, this embodiment provides a light-emitting device approximately the same as the embodiment I. The difference is that a carrier substrate 60 is provided under the package layer 30. A lower surface of the package layer 30 of this embodiment is mounted on the carrier substrate 60, and a lower surface of the carrier substrate 60 is provided with exposed SMT electrodes 50. The circuit layer 40 of the light-emitting device is provided within the encapsulation layer 30 on the carrier substrate 60. Connection wires between the SMT electrodes 50 and the circuit layer 40 pass through vias 61 of the carrier substrate 60. The carrier substrate 60 can provide sufficient rigid support for the encapsulation layer 30 to prevent deformation of the encapsulation layer 30 under a high temperature.

### Embodiment III

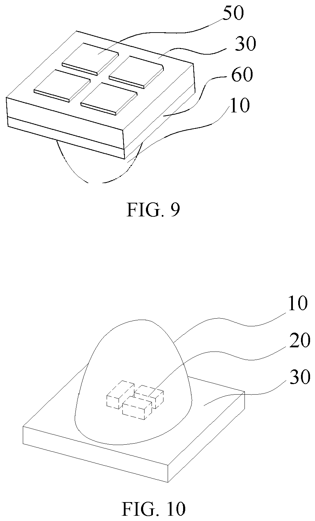

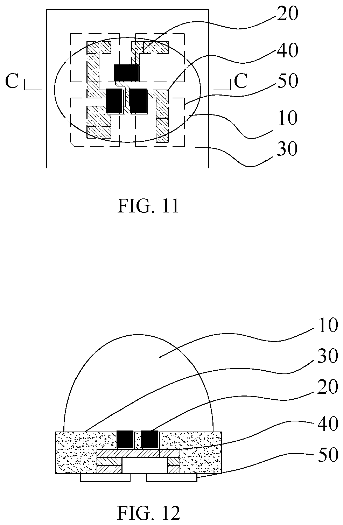

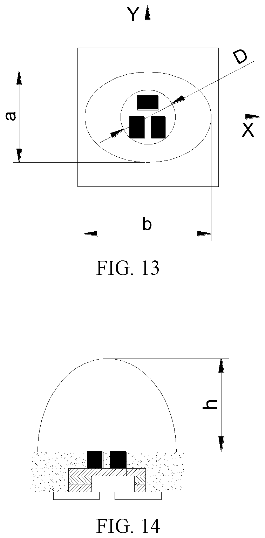

As shown in FIGS. 10-14, this embodiment provides a light-emitting device approximately the same as Embodiment I. The difference is that the three LED chips 20 in this embodiment are triangularly arranged. The maximum diameter D of the light-emitting region of three triangularly arranged LED chips 20 is 1mm or less. Similar to Embodiment I, the ratio a/b of the minor axis length a to the major axis length b of the semi-ellipsoid in this embodiment also satisfies the following condition: 0.4 ≤ a/b ≤ 0.9, and the minor axis length a is greater than or equal to 1.5 times the maximum diameter D of the light-emitting region, where a/b may any value from 0.4 to 0.9 (including 0.4 and 0.9), such as 0.4, 0.45, 0.7, 0.75, 0.8, 0.85, or 0.9, etc. The height h of the semi-ellipsoid is greater than 0.5a. The triangular arrangement enables the spacing between the LED chips 20 to be close to each other, which is more advantageous for light mixing.

### Embodiment IV

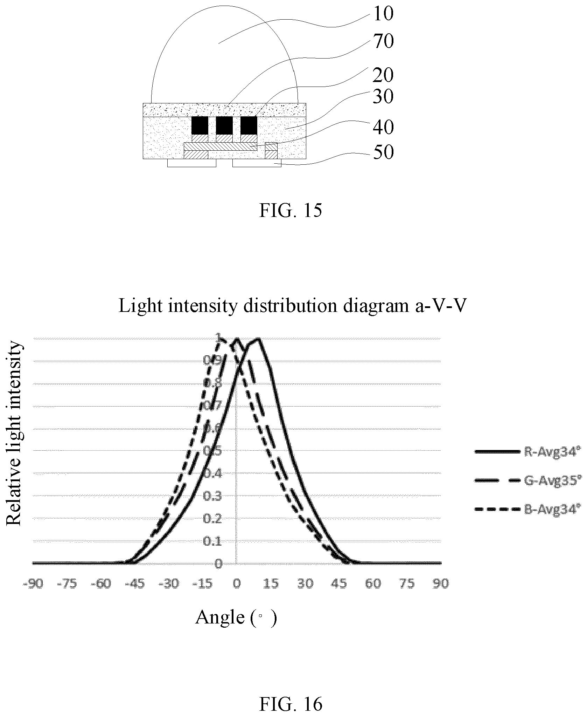

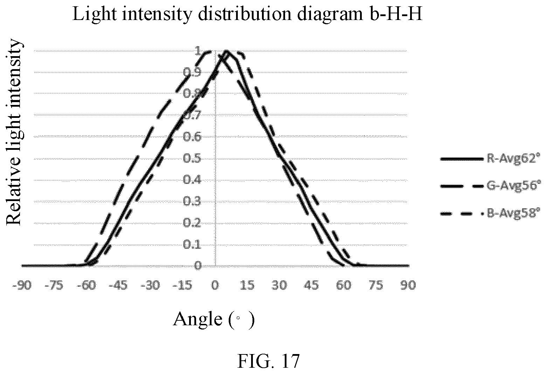

As shown in FIG. 15, this embodiment provides a light-emitting device approximately the same as the Embodiment I. The difference is that a light scattering and mixing layer 70 is further provided above the three LED chips 20. The light scattering and mixing layer 70 is formed by curing and molding light-transmitting silicone or resin with scattering particles uniformly distributed therein. The scattering particles in the light-emitting device of the present invention may be a kind of particle with scattering function, or a combination of multiple kinds of scattering particles, such as SiO2, TiO2 or a mixture of SiO2 and TiO2. The presence of the light scattering and mixing layer 70 improves the uniformity of light from the LED chips 20. As shown in FIG. 17, the light intensity distribution of the light-emitting device in this embodiment is more concentrated compared to the light intensity distribution of the existing light-emitting device in FIG. 16.

### Embodiment V

This embodiment provides a light-emitting device approximately the same as Embodiment IV. The difference is that the three LED chips 20 in this embodiment are triangularly arranged. The maximum diameter D of the light-emitting region of three triangularly arranged LED chips 20 is 1mm or less.

### Embodiment VI

This embodiment provides a display comprising an electrical connection unit, a case and a screen mounted on the case. The electrical connection unit electrically connects the screen to an external circuit. The screen having a light-emitting device of any one of the Embodiments I to IV mounted on it, and the light-emitting device is used as a pixel point mounted on the screen. The electrodes 50 of the light-emitting device is fixed by solder paste and electrically connected to a display circuit board of the connection unit. When the display of the present invention uses the light-emitting device of the present invention as a pixel unit mounted on the display, the encapsulation layer 30 reduces greatly the light interference of neighboring display units after the LED display is spliced.

### Embodiment VII

This embodiment provides a lighting device comprising a bracket and a light-emitting assembly. The light-emitting assembly is mounted on the bracket, and comprises a light-emitting device of any one of the Embodiments I to IV.

### Embodiment VIII

This embodiment provides a method of manufacturing a light-emitting device, comprising the steps of:
(1) providing at least three LED chips each comprising opposing first surfaces and second surface, and a side surface interconnecting the first surface and the second surface, the second surface having a pair of electrodes provided thereon; and adhering the first surfaces of the at least three LED chips to a tape spaced apart from each other, while making the second surfaces of the at least three LED chips face upward in the same plane;
(2) forming an encapsulation layer, making liquid colored silicone or resin fill the gaps between the at least three LED chips and cover the side surface of each the LED chip, exposing an electrode surface of each LED chip, and solidifying it;
(3) forming a circuit layer on the electrode surface of the at least three LED chips and connecting the circuit layer to the electrodes of the at least three LED chips;
(4) making an insulating layer on the circuit layer and exposing electrode leads of the circuit layer;
(5) removing the tape;
(6) making a light scattering and mixing layer on the first surfaces of the at least three LED chips.
   Mixing the granular scattering particles into silicone or resin, stirring evenly, coating it to an upper surface of the encapsulation layer and covering the first surfaces of at least three LED chips, and solidifying it after coating to complete the production of the light scattering and mixing layer.
(7) forming a lens on a light exiting surface of the LED chips.

A lens mold is fixed on the light scattering and mixing layer, and the cavity formed between the light scattering and mixing layer and the lens mold is filled with thermosetting silicone or epoxy resin, and after heating and molding, a lens mold-shaped lens is formed.

It should be noted that in the case that there is no light scattering and mixing layer, the lens mold can be fixed on the encapsulation layer, and the cavity formed between the encapsulation layer and the lens mold is filled with thermosetting silicone or epoxy resin, and after heating and molding, a lens mold-shaped lens is formed.

In summary, the light-emitting device of the present invention does not employ a conventional carrier substrate or support, but fixes the at least three LED chips by the encapsulation layer that covers the side surfaces of at least three LED chips and fills the gaps between the at least three LED chips. This structure not only improves the production efficiency, reduces the production cost of LED, and has no need to use adhesive for die bonding, reducing the spacing between the chips to be less than 30µm, and better controlling the consistency of the light-emitting angles of the light-emitting device. The light-emitting device of the present invention has a lens provided above the light-emitting region of at least three LED chips, which changes the approximately Lambertian light distribution of the LED chips, and provides a special light distribution. The special light distribution allows the light to be more concentrated on desired areas, which effectively improve the utilization of light energy, reduces the energy consumption and cost of the light source, while avoiding light pollution from the light source to the non-illuminated areas and other issues. Therefore, the present invention effectively overcomes the shortcomings of the prior art and has a high industrial value.

The above-mentioned embodiments only exemplarily illustrate the principles and effects of the present invention, and are not used to limit the present invention. Anyone familiar with this technology can modify or change the above-mentioned embodiments without departing from the spirit and scope of the present invention. Therefore, all equivalent modifications or changes made by those with ordinary knowledge in the technical field without departing from the spirit and technical ideas disclosed in the present invention should still be covered by the claims of the present invention.

## Claims

1. A light-emitting device, comprising:
at least three LED chips that are spaced apart from each other, each of the LED chips being configured to emit light of a respective wavelength, a maximum diameter D of a light-emitting region of the at least three LED chips being 1 mm or less, each of the LED chips comprising a first surface and a second surface opposite to the first surface, and a side surface interconnecting the first surface and the second surface;
an encapsulation layer that covers the side surfaces of the at least three LED chips and fills gaps between the at least three LED chips; and
a lens provided above the first surfaces of the at least three LED chips and that covers the light-emitting region of the at least three LED chips.

2. The light-emitting device of claim 1, **characterized in that** a luminous power emitted from the encapsulation layer is less than 30% of a total luminous power.

3. The light-emitting device of claim 2, **characterized in that** the encapsulation layer is filled with colored silicone or silicone resin with a transmittance less than or equal to 20%.

4. The light-emitting device of claim 1, **characterized in that** a contact surface between the lens and the encapsulation layer is approximately an ellipse with a ratio a/b of a minor axis length a to a major axis length b greater than or equal to 0.4, and less than or equal to 0.9, the minor axis length a is greater than or equal to 1.5 times the maximum diameter D of the light-emitting region, and a height h of the semi-ellipsoid is greater than 0.5a.

5. The light-emitting device of claim 4, **characterized in that** the lens is in a semi-flat ellipsoid shape, and an approximately elliptical surface is formed at the connection between the lens and encapsulation layer; a half-value angle corresponding to the minor axis is α, and a half-value angle corresponding to the major axis is β, where α<β, 20°<α<70°.

6. The light-emitting device of claim 4, **characterized in that** when looking down from the lens side towards the LED chip side, the geometric center of the light-emitting region of the at least three LED chips coincide with an optical axis of the lens.

7. The light-emitting device of claim 1, **characterized in that** the lens is made of silicone or resin by an injection molding process.

8. The light-emitting device of claim 1, **characterized in that** the at least three LED chips each have a size of 380 µm x 380 µm or less.

9. The light-emitting device of claim 1, **characterized in that** a spacing between the at least three LED chips is 50µm or less.

10. The light-emitting device of claim 1, **characterized in that** the light-emitting assembly does not have a packaging substrate for carrying the LED chips, and the LED chips are held in position by the encapsulation layer.

11. The light-emitting device of claim 1, **characterized in that** a carrier substrate is provided under the encapsulation layer, a lower surface of the carrier substrate is provided with exposed electrodes, a circuit layer of the light-emitting device is provided in the encapsulation layer on the carrier substrate, and connection wires between the electrodes and the circuit layer extend through vias within the carrier substrate.

12. The light-emitting device of claim 1, **characterized in that** a light scattering and mixing layer is further provided above the at least three LED chips.

13. The light-emitting device of claim 12, **characterized in that** the light scattering and mixing layer is formed by curing and molding light-transmitting silicone or resin with scattering particles uniformly distributed therein.

14. The light-emitting device of claim 1, **characterized in that** the light-emitting device comprises only three LED chips, which are respectively a R-light chip, a G-light chip and a B-light chip.

15. The light-emitting device of claim 14, **characterized in that** the three LED chips are triangularly arranged or linearly arranged.

16. The light-emitting device of claim 1, **characterized in that** cathodes or anodes of at least three LED chips are led out through a common-cathode electrical connection structure or a common-anode electrical connection structure.

17. The light-emitting device of claim 1, **characterized in that** exposed electrodes are provided on a side of the light-emitting device opposite to the first surface.

18. The light-emitting device of claim 17, **characterized in that** the electrodes are SMT electrodes capable of being soldered.

19. The light-emitting device of claim 1, **characterized in that** a circuit layer of the light-emitting assembly is provided within the encapsulation layer on the second surface side of the at least three LED chips.

20. A display, comprising an electrical connection unit, a case and a screen mounted on the case, **characterized in that** there is also a light-emitting device of any one of claims 1-19, the light-emitting device being mounted on the screen as a pixel point.

21. Alighting apparatus, comprising a bracket and a light-emitting assembly mounted on the bracket, **characterized in that** the light-emitting assembly comprises a light-emitting device of any one of claims 1-19.

22. A manufacturing method for a light-emitting device, **characterized in that** the method comprises the steps of:
(1) providing at least three LED chips, the LED chip comprising a first surface and a second surface opposite to the first surface, and a side surface interconnecting the first surface and the second surface, the second surface having a pair of electrodes provided thereon; and adhering the at least three LED chips to a tape spaced apart from each other, while making the second surfaces of the at least three LED chips face upward in the same plane;
(2) forming an encapsulation layer that fills the gaps between the at least three LED chips and covers the side surface of each LED chip, exposing an electrode surface of each LED chip;
(3) forming a circuit layer on the electrode surfaces of the at least three LED chips, and connecting the circuit layer to the electrodes of the at least three LED chips;
(4) making an insulating layer on the circuit layer, exposing electrode leads of the circuit layer;
(5) removing the tape; and
(6) forming a lens on light exiting surfaces of the LED chips.

23. The manufacturing method of claim 22, **characterized in that** between steps (5) and (6), the method further comprises a process of making a light scattering and mixing layer above the plurality of chips.

24. The manufacturing method of claim 22, **characterized in that** the encapsulation layer is formed by curing and molding colored silicone or silicone resin with a transmittance less than or equal to 20%.

25. The manufacturing method of claim 22, **characterized in that** the lens is made of silicone or resin by an injection molding process.
